# EUROPEAN PATENT SPECIFICATION

(11) **EP 0 310 702 B1**
(45) Date of publication and mention of the grant of the patent: **08.01.1997**
(21) Application number: 87114794.8
(22) Date of filing: 09.10.1987
(51) Int. Cl.: H01L 27/14, H01L 31/02

(54) **Method of operating photo-sensor units**
Verfahren zum Betreiben von Photosensor-Einheiten
Méthode pour opérer des unités photosensibles

(43) Date of publication of application: 12.04.1989
(60) Divisional application: 93112880.5
(73) Proprietor: CANON KABUSHIKI KAISHA, Tokyo (JP)
(72) Inventor: Itabashi, Satoshi, Atsugi-shi Kanagawa-ken (JP); Saika, Toshihiro, Hiratsuka-shi Kanagawa-ken (JP); Gofuku, Ihachiro, Hiratsuka-shi Kanagawa-ken (JP)
(74) Representative: Tiedtke, Harro, Dipl.-Ing.

(56) References cited:
- EP-A- 0 232 083
- JP-A-55 074 262
- PATENT ABSTRACTS OF JAPAN, vol. 9, no. 270 (E-353)[1993], 26th October 1985; & JP-A-60 115 259

## Description

### BACKGROUND OF THE INVENTION

### Field of the Invention

The present invention relates to a method of operating photo-sensor units in an image reading device of the type having a one-dimensional image sensor such as a line sensor adapted to read an image on an image carrier such as an original document which is moved relatively to the line sensor in close contact therewith. The image reading device of the invention is suitable for use in, for example, facsimiles, copiers and image readers.

Document EP-A-0 232 083 discloses a respective method of operating photo-sensor units. Each photo-sensor unit includes a light-shielding layer made of an electrically conductive material and formed on a light-transmitting substrate, an insulating layer formed on said light-shielding layer, a semiconductor layer formed on said insulating layer, and a pair of upper electrodes provided on said semiconductor layer and spaced from each other, wherein the space between said upper electrodes constitutes a light-receiving portion. Light is applied from the reverse side of said light-transmitting substrate through a window in said light-shielding layer, said insulating layer, said semiconductor layer and said upper electrodes onto an image-carrying original which is then reflected by said original so that light reaches said light receiving portion of said photo-sensor unit.

In an image reading device using a conventional method of operating photo-sensor units the line image is focused through a real-size optical system on an elongated line sensor having a length substantially equal to the length of the original as measured in the direction of the main scan. It is rather easy for this type of image reading device to have a reduced size, because the size of the space accommodating the optical system is much smaller than that in the first-mentioned type of the image reading device. The real-size optical system can be constituted by, for example, converging optical fibers or a contact lens array.

The converging optical fibers and the contact lens array, however, are generally expensive so that the cost of the image reading device is raised undesirably.

Under these circumstances, the present applicant has proposed a contact-type image reading method in which an original carrying the image to be read is moved relative to a one-dimensional line sensor in direct contact therewith. This method is disclosed, for example, in Japanese Patent Application Laid-Open Publication Nos. 74262/1980, 45084/1981 and 122172/1981.

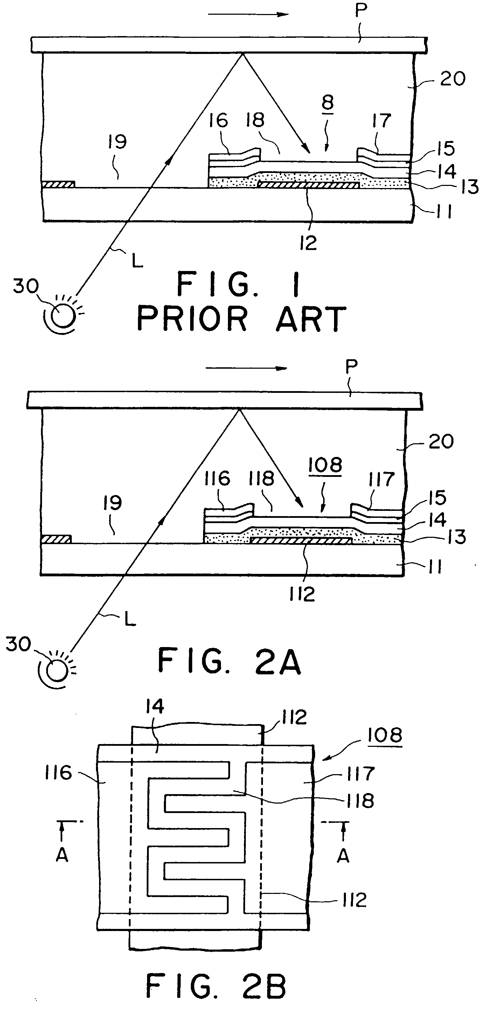

Fig. 1 is a schematic fragmentary sectional view of an essential portion of the contact-type image reading device showing a conventional method of operating photo-sensor units. The device has a sensor 8 constituted by a one-dimensional line sensor which is arranged on a transparent substrate 11 such as a sheet of glass such as to extend in the direction perpendicular to the plane of the drawing.

The sensor 8 has a multi-layer structure constituted by a light-shielding layer 12 made of a light-shielding material such as a metal and placed on the transparent substrate 11, an insulating layer 13 made of an electrically insulating material and laid on the light-shielding layer 12, and a photoconductive semiconductor layer 14 formed on the insulating layer 13 and made of a photoconductive semiconductor material such as hydrogenerated amorphous silicon (referred to as "a-Si : H, hereinunder) and CDs·Se. A pair of main electrodes 16 and 17 are formed on the semiconductor layer 14 through an intermediary of a semiconductor layer 15 which is made of a semiconductor material doped with a semiconductor impurity for the purpose of attaining the ohmic contact. The area between the pair of main electrodes 16 and 17 constitutes a light-receiving window 18.

In operation, a light L from-a light source 30 enters through a window 19 formed in the transparent substrate 11 so as to illuminate an original P and is reflected by the image. The reflected light then impinges upon the window 18 of the sensor 8 thereby to produce a photoelectric current which flows between the main electrodes 16 and 17 through the semiconductor layer 14. This photoelectric current is detected as the reading signal.

According to this arrangement, the light from the light source 30 enters from the reverse side of the substrate 11. If the sensor 8 lacks the light-shielding layer 12, a portion of the light emitted from the light source will directly reach the sensor 8 in addition to the light reflected by the image. The light directly reaching the sensor 8 will produce a steady photoelectric current so as to a large noise, resulting in an impractically low S/N ratio which is in this case the ratio between the signal photoelectric current produced by the reflected light and the noise produced mainly by the steady current. It is therefore essential that the sensor 8 has a light-shielding layer 12. In order to shield the light which would directly reach the sensor 8 without fail, the light-shielding layer 12 is required to have a sufficiently large light-shielding power. In addition, the light-shielding layer 12 preferably has a small thickness. To comply with these demands, the light-shielding layer is made of a metal or a similar material.

A reading resolution on the order of 4 to 8 lines/mm is obtainable when the clearance of about 0.1 mm is maintained between the original P and the sensor 8. In order to maintain the required resolution, the clearance between the original P and the sensor 8 has to be controlled precisely. Such a precise control of the clearance can be attained by, for example, forming a transparent protective layer 20 on the upper side of the sensor 8.

In general, the sensor 8 of an image reading device is required to meet various demands such as reduced dark current, large S/N ratio and high linearity of the output current Iₚ in relation to the incident light.

As explained before, the contact-type image reading device using a conventional method of operating photo-sensor units essentially requires a light-shielding layer 12. Hitherto, however, no specific consideration has been given to the potential of the light-shielding layer 12. In consequence, the light-shielding layer is electrically floated and held in unstable state. This in turn makes the band state of the semiconductor layer 14 contacting the insulating layer 13 on the light-shielding layer 12 unstable, resulting in an unstable photoelectric current as the output.

The semiconductor layer 14, when formed from a-Si : H has n⁻ conduction type so that the flat band voltage is slightly negative, as will be understood from a C-V curve which will be mentioned later. Therefore, a weak accumulation is caused at the boundary between the light-shielding layer 12 and the insulating layer 13. This inconveniently increases the level of the dark current resulting in a degradation of the quality of the reading output.

It has therefore been strongly desired to eliminate the above-described problems encountered by the known image reading device using a conventional method of operating photo-sensor units.

### SUMMARY OF THE INVENTION

Accordingly it is an object of the present invention to provide a method of operating photo-sensor units in order to improve their characteristics such as linearity, S/N ratio and stability.

According to the present invention this object is achieved by a method of operating photo-sensor units, each photo-sensor unit including a light-shielding layer made of an electrically conductive material and formed on a light-transmitting substrate, an insulating layer formed on said light-shielding layer, a semiconductor layer formed on said insulating layer, and a pair of upper electrodes provided on said semiconductor layer and spaced from each other, the space between said upper electrodes constituting a light-receiving portion, wherein light is applied from the reverse side of said light-transmitting substrate through a window in said light-shielding layer, said insulating layer, said semiconductor layer and said upper electrodes onto an image-carrying original which is then reflected by said original so that light reaches said light receiving portion of said photo-sensor unit, said method of operating said photo-sensor units being characterized by the steps of applying a first bias voltage having the polarity of the carrier mainly carrying a photoelectric current generated in said semiconductor layer to each of said light-shielding layers in a reading period, and applying a second bias voltage having the same polarity as said first bias voltage and an absolute value smaller than that of said first bias voltage to each of said light-shielding layer in a non-reading period.

Thus, by applying two different bias voltages during the reading and the non-reading period of the photo-sensor unit the characteristics of the photo-sensor unit are remarkably improved.

The advantages of the invention will become apparent and obvious to those skilled in the pertinent art upon referring to the following description provided in connection with the accompanying drawings, of which:

### BRIEF DESCRIPTION OF THE DRAWINGS

Fig. 1 is a schematic fragmentary sectional view of an essential portion of a known image reading device using a conventional method of operating photo-sensor units;
Fig. 2A is a schematic fragmentary sectional view of an essential portion for applying the method of operating photo-sensor units in accordance with the present invention;
Fig. 2B is a schematic plan view of the essential portion of the first embodiment as shown in Fig. 2A;
Fig. 3A is a schematic plan view of a further portion for applying the method of operating photo-sensor units in accordance with the present invention;
Fig. 3B is a sectional view taken along the line B - B of Fig. 3A;
Fig. 3C is a sectional view taken along the line C - C of Fig. 3A;
Fig. 4 is an equivalent circuit diagram of a circuit equivalent explaining the method of operating photo-sensor units of the present invention;
Fig. 5 is a graph showing a change in capacitance in relation to a bias voltage V_{sg} in the photo-sensor as shown in Fig. 3;
Fig. 6 is a graph showing the relationship between the actually measured values of photoelectric current Iₚ and an α value in relation to the bias voltage V_{sg};
Fig. 7 is a schematic plan view of still a further essential portion for applying the method of operating photo-sensor units in accordance with the present invention;
Fig. 8 is an equivalent circuit diagram of an equivalent circuit of the portion as shown in Fig. 7;
Fig. 9 is a timing chart illustrating voltage waveform in a preferred example of the method of operating photo-sensor units in accordance with the present invention;
Figs. 10A and 10B are waveform charts illustrating a change in the output current;
Fig. 11 is a schematic illustration of an image reading device for applying the method of operating photo-sensor units in accordance with the present invention;
Fig. 12 is a schematic sectional view of an example of the photoelectric conversion section in the device shown in Fig. 11;
Fig. 13 is a schematic plan view of still a further essential portion for applying the method of operating photo-sensor units in accordance with the present invention; and
Fig. 14 is a schematic sectional view showing still a further essential portion for applying the method of operating photo-sensor units in accordance with the present invention.

### DESCRIPTION OF THE PREFERRED EMBODIMENTS

Preferred embodiments of the present invention will be described hereinunder with reference to the accompanying drawings.

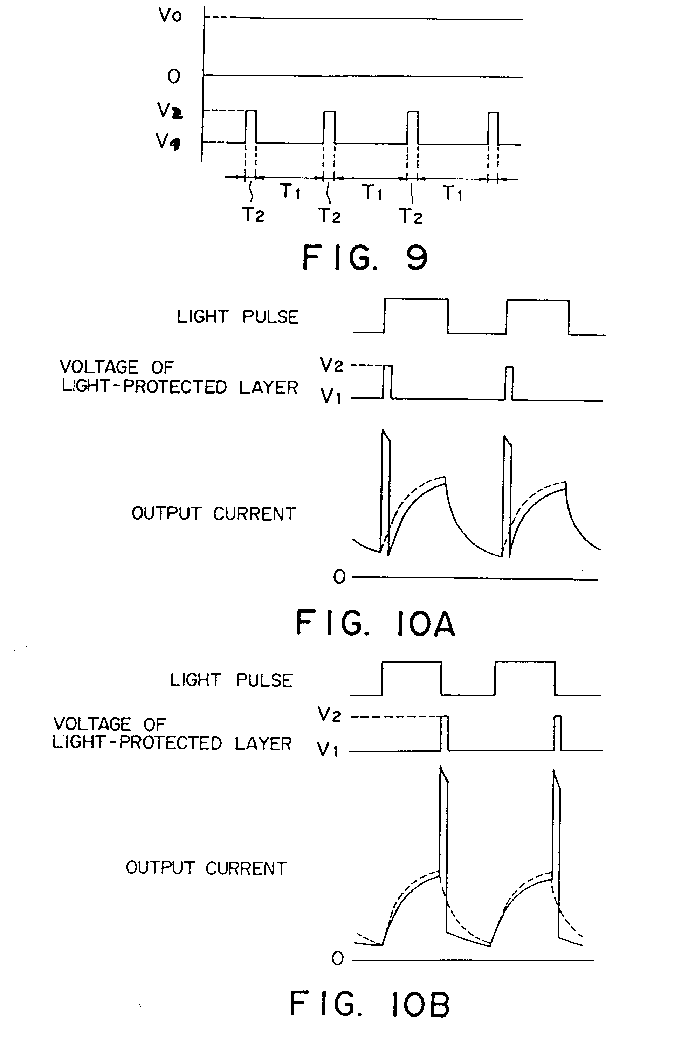

Fig. 2A is a schematic sectional view of an essential portion for applying the method of operating photo-sensor units in accordance with the present invention, taken along the A - A in Fig. 2B which is a plan view of a sensor unit. In these Figures, the same reference numerals are used to denote the same parts or members as those appearing in Fig. 9.

The first embodiment of the essential portion has a sensor unit 108 which includes a light-shielding layer 112 made of an electrically conductive material such as a metal and is connected to a later-mentioned electrical driving system in such a manner as to constitute a gate electrode which cooperates with a pair of main electrodes 116 (source electrode) 117 (drain electrode). The main electrodes 116 and 117 have comb-like forms such as to mate oppose each other thereby forming a zig-zag light-receiving window 118 therebetween as shown in Fig. 2B. The light reflected by the original P is received by the portion of the semiconductor layer 14 exposed through the window 118, so as to be converted into photoelectric current.

The sensor unit 108 shown in Figs. 2A and 2B corresponds to one bit (cell) of the image reading. It is possible to form a one-dimensional line sensor by arraying a plurality of such sensor units 8 on a substrate 11. For instance, by arraying 1728 pieces of such sensor unit 108 in the direction of width of the original P, i.e., in the direction perpendicular to the original feeding direction indicated by an arrow in Fig. 2A, it is possible to obtain a reading resolution of 8 lines/mm over a width (216 mm) of A-4 size paper. The image reading device for applying the method of operating photo-sensor units further has charge accumulating units (capacitor units) for accumulating the outputs from the photo-sensor units, switch units for transferring the accumulated charges for the purpose of signal processing, and necessary wiring patterns. These units may be formed on the substrate in a single production process.

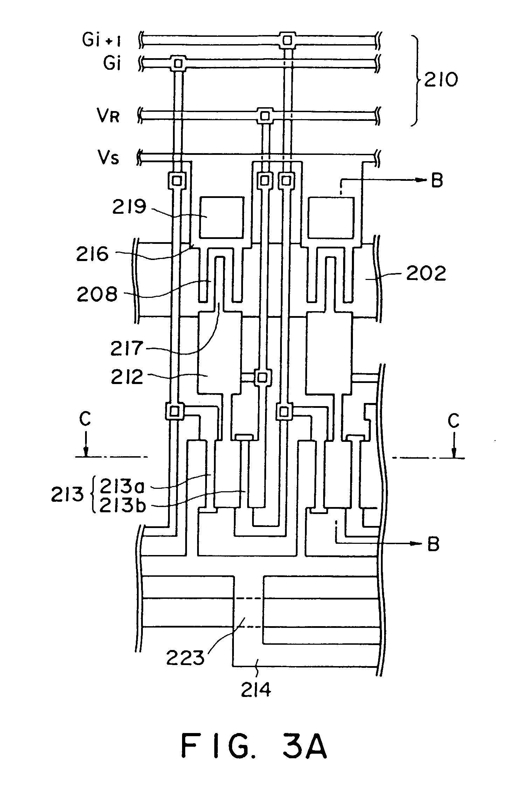

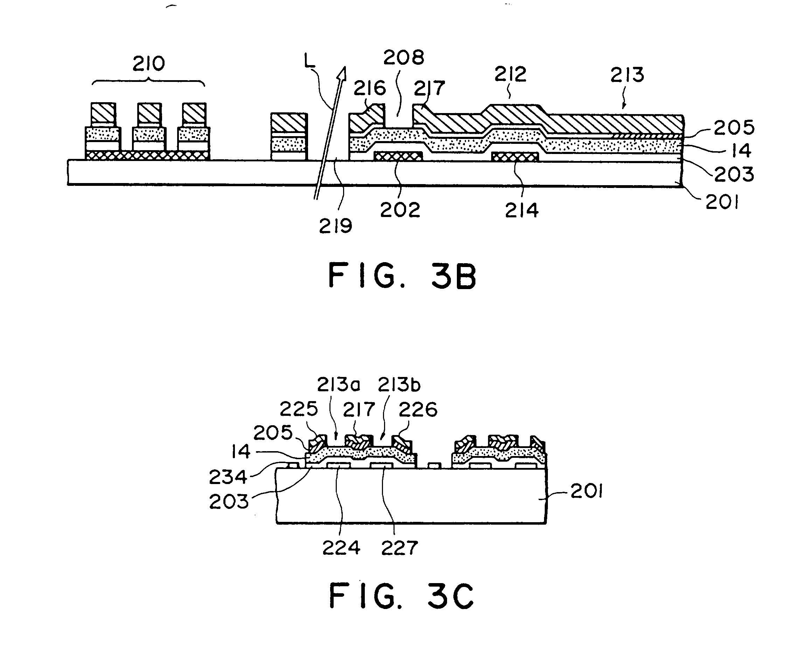

Fig. 3A is a plan view of a further portion for applying the method of operating photo-sensor units in which the photo-sensor units, charge accumulating units and switch units are formed integrally. Figs. 3B and 3C are sectional views taken along the lines B - B and C - C of Fig. 3A, respectively.

This image reading device has a plurality of units each having a gate matrix wiring portion 210, a photo-sensor unit 208, a charge accumulating unit 212, a switch unit 213 including a transfer switch 213a and a discharge switch 213b for resetting the charge accumulating unit 212, a wiring for transferring the output from the transfer switch 213a to a later-mentioned signal processing unit, and a load capacitor for accumulating and reading the charges transferred through the transfer switch 213a.

The photoconductive semiconductor layer 14 commonly used for the photo-sensor unit 208, transfer switch 213a and the discharge switch 213b is made of an a-Si:H film, while an insulating layer 203 is constituted by silicon nitride layer (SiNH) formed by a glow discharge.

Fig. 3A shows only the upper and lower electrode wiring layers. Namely, the photoconductive semiconductor layer 14 and the insulating layer 203 are omitted for the purpose of clarification of the drawing. The photoconductive semiconductor layer 14 and the insulating layer 203 are commonly used for the photo-sensor unit 208, charge accumulating unit 212, transfer switch 213a and the discharge switch 213b. These layers 14 and 203 also have portions placed between the upper electrode wiring and the substrate. In order to attain an ohmic contact, an a-Si:H layer doped in n⁺ type is disposed between the upper electrode wiring and the photoconductive semiconductor layer.

The wiring pattern in the line sensor used in this embodiment is such that the output signal lines from the photo-sensor units 208 do not intersect or cross other lines so as to eliminate any cross-talk between signal components and induction noise which may otherwise be caused by the gate electrode wiring.

The photo-sensor unit 208 has upper electrode wirings 216 and 217. The light entering through the incidence window 219 is reflected by the original surface and impinges upon the photoconductive semiconductor layer 14 so as to cause a change in the electric current flowing between the comb-shaped opposing upper electrode wirings 216 and 217. A reference numeral 202 denotes a light-shielding layer made of an electrically conductive and light-shielding material such as a metal and connected to a later-mentioned electric driving unit.

The charge accumulating unit 212 is composed of a lower electrode wiring 214, a dielectric portion constituted by an insulating layer 203 formed on the lower electrode wiring 214 and the photoconductive semiconductor layer 14, and an electric wiring which is an extension of the upper electrode wiring 217 of the photo-sensor unit 208 and laid on the photoconductive semiconductor layer 14. The charge accumulating unit 212 has a construction which is the same as that known as MIS (Metal-Insulating-Semiconductor) capacitor. The charge accumulating unit 212 can operate either with a positive or a negative bias. It is, however, to be noted that stable capacitance and frequency characteristics are obtained by negatively biasing the lower electrode wiring 214.

Fig. 3C shows the switch unit 213 which has the transfer switch 213a and the discharge switch 213b and is constructed as a thin-film-type transistor (TFT). The transfer switch 213a is constituted by a lower electrode wiring 224 serving as a gate electrode, an insulating layer 203 serving as a gate insulating layer, a photoconductive semiconductor layer 14, an upper electrode wiring 225 serving as a source electrode, and an upper electrode wiring 217 serving as a drain electrode. The discharge switch 213b has a gate insulating layer and the photoconductive semiconductor layer which are constituted by the insulating layer 203 and the photoconductive semiconductor layer 14 mentioned before. The discharge switch also has a source electrode constituted by an upper electrode wiring 117, gate electrode constituted by the lower electrode wiring 227 and a drain electrode constituted by the upper electrode wiring 226. A reference numeral 234 denotes a lower wiring connected to the gate electrode of a transfer switch 213a.

As has been described, the n⁺ type a-Si:H layer 205 is provided between the upper electrode wirings 217, 225 and 226 and the photoconductive semiconductor layer 14, so as to provide the ohmic contact.

The line sensor having the described construction can be produced by a single process because all of the constituents such as the photo-sensor unit 208, charge accumulating unit 212, transfer switch 213a, discharge switch 213b and matrix wirings have laminated structures including layers such as the photoconductive semiconductor layer 14 and the insulating layer 203.

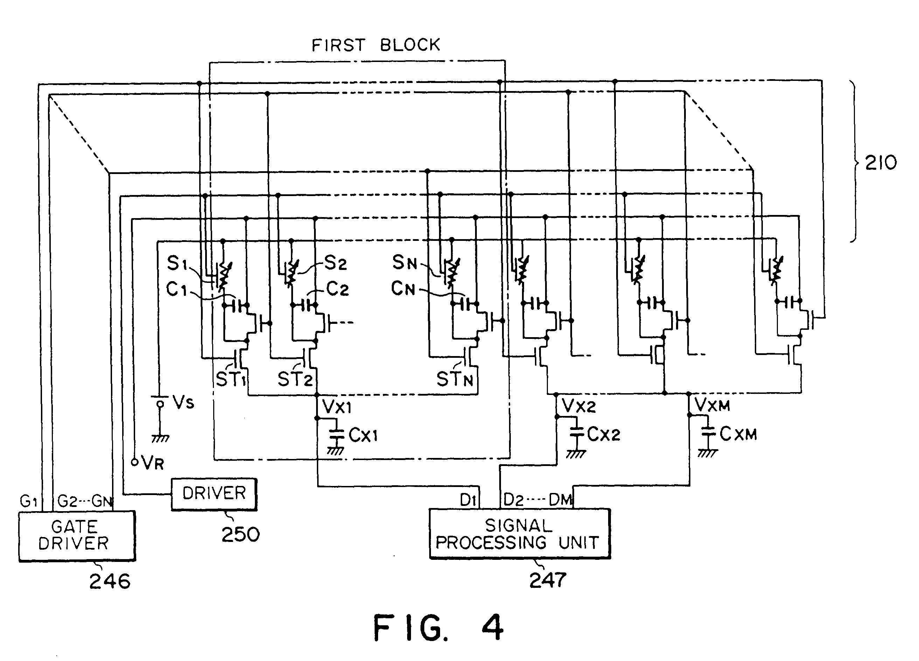

Fig. 4 shows a circuit which is equivalent to the image reading device for applying the method of operating photo-sensor units as shown in Figs. 3A to 3C.

The circuit includes photo-sensor units S1, S2, ....., SN (represented by SY1, hereinafter), charge accumulating capacitors C1, C2, ....., CN (hereinafter CY1) constituting the charge accumulating units 212 adapted for accumulating the photoelectric current from the photo-sensor units SY1, transfer switch units ST1, ST2, ....., STN (hereinafter STY1) corresponding to the transfer switches 213a and adapted for transferring the charges of the accumulating capacitors CY1 to load capacitors CX1 which correspond to the load capacitors 223, and discharge switches SR1, SR2 ....., SRN (hereinafter RY1) corresponding to the discharge switches 213b and adapted for resetting the charges on the accumulating capacitors CY1.

The photo-sensor units SY1, accumulating capacitors CY1, transfer switches STY1 and the discharge switches SRY1 are arrayed in respective rows. The image reading device is sectioned into M blocks each including N pieces of photo-sensor units SY1, N pieces of accumulating capacitors CY1, N pieces of transfer switches STY1 and N pieces of discharge switches SRY1. For instance, when a line sensor is composed of 1728 of such photo-sensor units SY1, these units are divided into M blocks, e.g., 54 blocks, each containing N units, e.g., 32 units. The gate electrodes of the transfer switches STY1 and discharge switches SRY1 arranged in arrays are connected to the matrix wiring portion 210. The gate electrode of each transfer switch STY1 in each block is commonly connected to the gate electrodes of the transfer switches STY1 of the same order in other blocks. The gate electrode of each discharge switch SRY1 of each block is connected in a cyclic manner, i.e., to the gate electrode of the transfer switch SRY1 on the next order in the same block.

The common wiring (gate driving lines G1, G2 ....., GN) of the matrix wiring 210 are driven by a gate driving unit 246. On the other hand, the signal output is connected to the signal processing unit 247 through lead lines 214, i.e., signal output lines D1, D2 ....., DN.

The gate electrodes (light-shielding layers 202) of the photo-sensor units S1, ....., SN, ....., SN x M are connected to a driving source 250 and are supplied with negative bias voltage.

The gate driving lines G1, G2, ....., GN are successively supplied with selection pulses VG1, VG2, VG3, ....., VGN from the gate driving unit 246. When the gate driving line G1 is selected, the transfer switch ST1 is turned on and the charges accumulated in the charge accumulating capacitor C1 are transferred to the load capacitor CX1. Then, the next gate driving line G2 is selected so that the next transfer switch ST2 is turned on, whereby the charges accumulated in the charge accumulating capacitor C2 are transferred to the load capacitor CX2 and, at the same time, the accumulating capacitor C1 is reset by means of the discharge switch SR1. In the like manner, driving lines G3, G4, ....., GN are successively selected and reading operation is successively conducted. This operation is conducted for each of the plurality of blocks. The outputs VX1, VX2, ....., VXM are transmitted to the input sections D1, D2, ....., DM of the signal processing unit 247 so as to be changed into a serial output signal from the signal processing unit 247.

A negative bias voltage is applied to the gate electrodes of the photo-sensors S1, ....., SN, x M, for the following reason. reason.

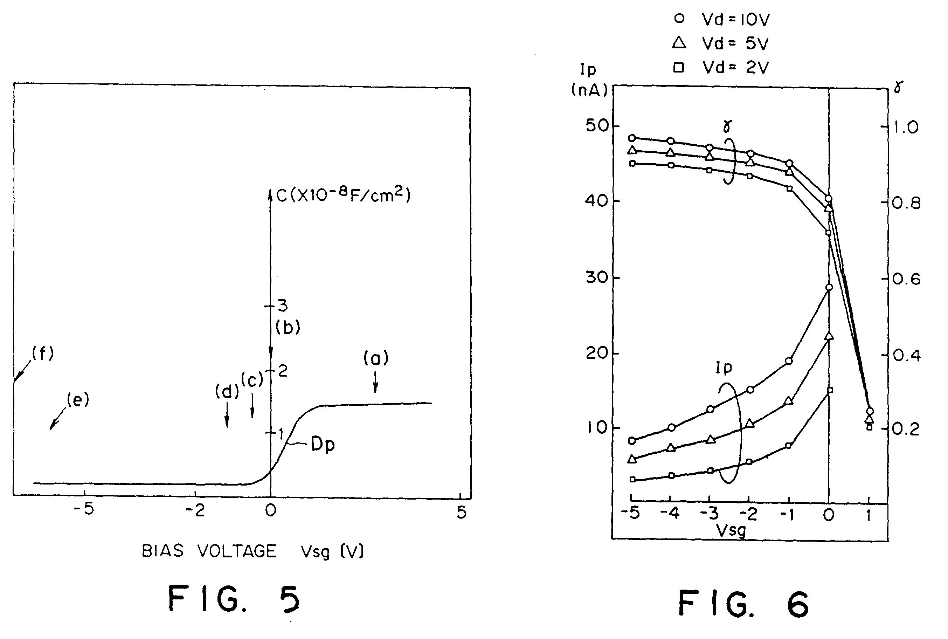

Fig. 5 illustrates a change in the capacitance formed between the light-shielding layer 112 and the upper electrodes 116, 117 as observed when the insulating layer 203 and the semiconductor layer 14 of the sensor as shown in Fig. 3A are formed from an SiNH film of 3,000 A and α-Si:H film of 4,000 A, respectively (10Å = 1 nm). This capacitance includes the capacitances provided by the insulating layer 203 and the semiconductor layer 14. A curve Cₚ shows a change in the capacitance as obtained in a dark state, i.e., when there is no input light. A depletion layer formed in the semiconductor layer 14 progressively becomes greater in the thicknesswise direction as the absolute value of the negative bias voltage is increased. In consequence, the capacitance Cₚ gradually decreases as the absolute value of the negative bias voltage V_{sg} increases. From this graph, it will be seen that the depletion layer spreads over the entire thickness of the semiconductor layer 14 when the bias voltage V_{sg} is -1V. This means that any unfavourable effect produced by the capacitance in the dark state, i.e., any influence of the dark current, can be eliminated by applying to the gate electrode a negative bias voltage which is below -1V and selected to provide a certain level of capacitance when illuminated by light. It is thus possible to improve the S/N ratio by applying such a negative bias voltage.

Fig. 6 shows a graph illustrating the photoelectric current Iₚ in relation to the bias voltage V_{sg} and the light-quantity-dependency (linearity) of the sensor characteristics represented by γ. A condition represented by γ = 1 represents an ideal state. The characteristics as shown in Fig. 6 have been obtained through a test conducted by varying the voltage applied to the drain electrode (electrode 117 in Fig. 2A and electrode 217 in Fig. 3A) of the photo-sensor. The photo-sensor used in the experiment had an a-Si:H semiconductor layer 14 of 4,000 A thick. The values of the photoelectric current Iₚ, linearity γ and the S/N ratio were evaluated for each of the points (a) to (f) shown in Fig. 5, the results of which are shown in the following Table 1.

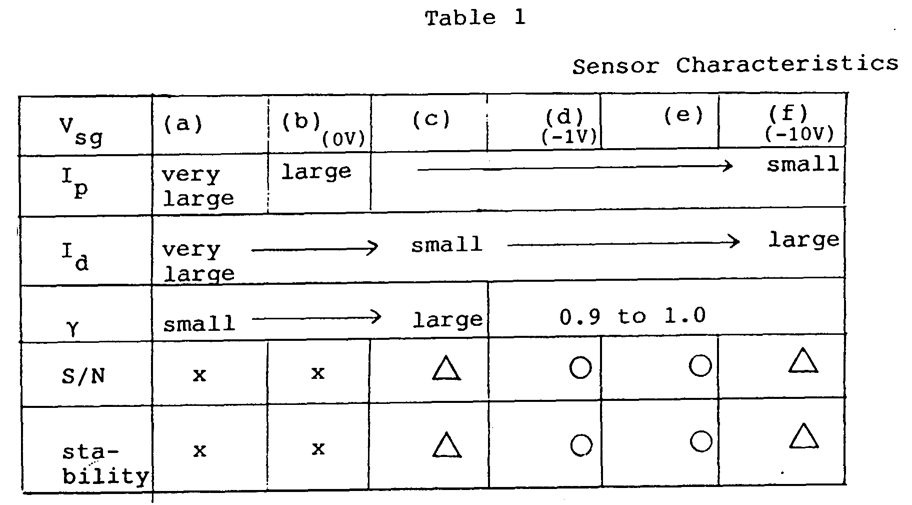

where,
- ○: represents excellent,
- Δ: represents good, and
- x: represents not so good.

A discussion on Table 1 above will prove that the depletion layer spreads over the entire thickness of the semiconductor layer 14 so as to reduce the dark current to a negligibly low level when the voltage V_{sg} is -1V and that appreciable effects in the improvements of the γ value and the S/N ratio can be obtained by applying a bias voltage below this level to the gate electrode of the photo-sensor. It is to be understood, however, a bias voltage not higher than - (minus) 10V degrades the S/N ratio due to an increase in the influence of the noise and reduction in the signal level Iₚ, though the γ value is appreciably high.

Therefore, the driving unit 250 is constructed as a power supply capable of varying the output voltage which is adjusted such that a bias voltage which is on the order of -1V to -10V with respect to the low potential of the upper electrode, thereby attaining a high stability of the sensor characteristics.

From the foregoing description, it will be understood that a depletion layer is formed in the photoelectric converting semiconductor layer by applying a suitable level of negative bias voltage to the gate electrode constituted by the light-shielding layer 112, 202, and that the unfavourable effect produced by the dark current is eliminated to improve the S/N ratio while attaining a high linearity of the light-quantity-dependency.

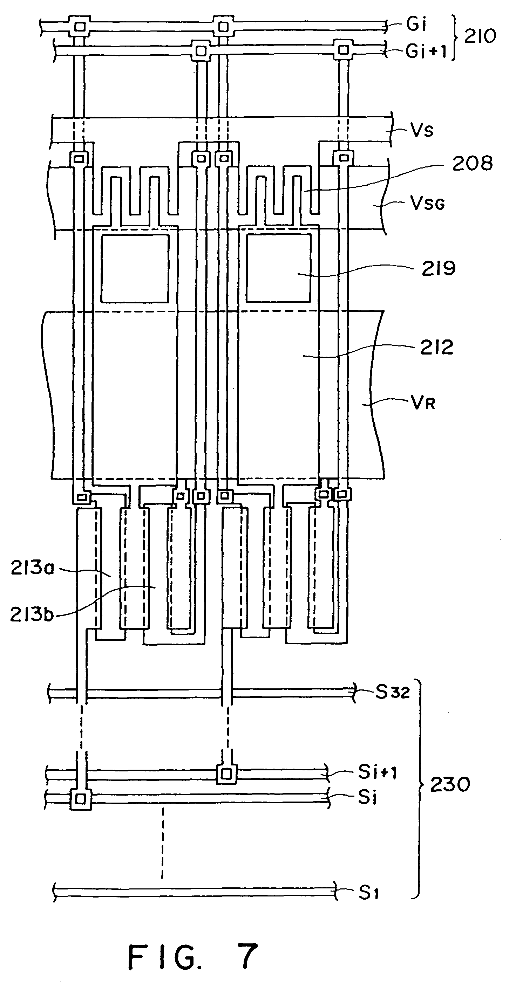

Fig. 7 shows a further portion for applying the method of operating photo-sensor units in which the photo-sensor unit 208, charge accumulating unit 212 and the switch unit 213 are formed as a unit. In this Figure, the same reference numerals are used to denote the parts or members which may have the same constructions as those in the portions shown in Figs. 3A to 3C. In Fig. 7, a reference numeral 230 denotes an output signal matrix.

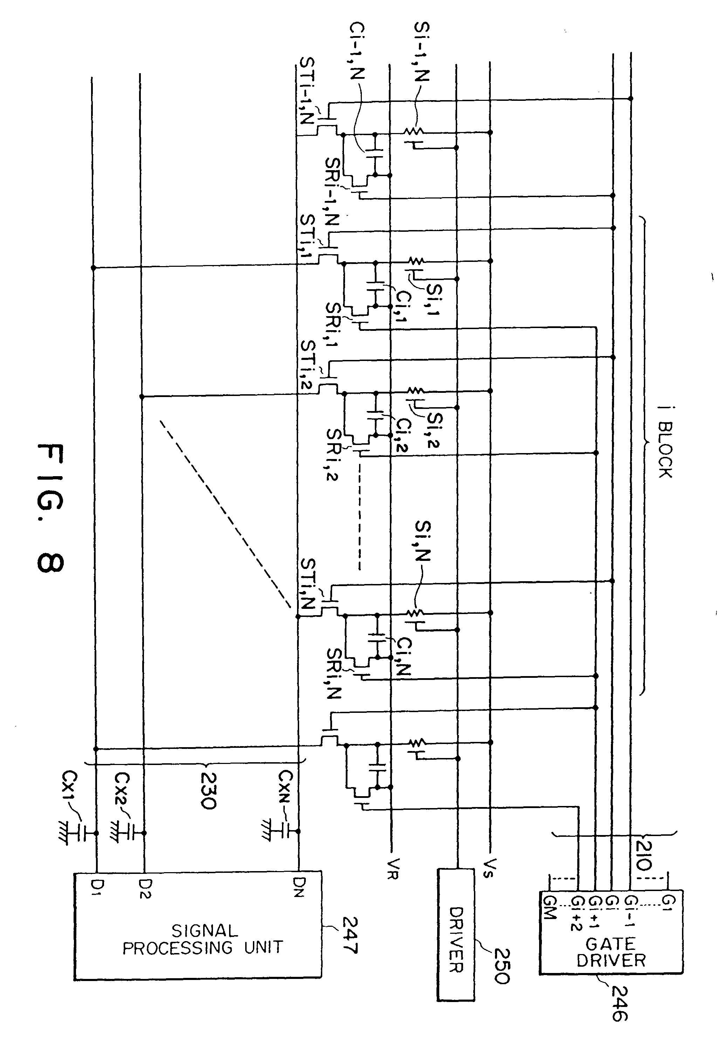

Fig. 8 shows a circuit which is equivalent to the device shown in Fig. 7.

The device of this embodiment has photo-sensor units S_{i,1}, S_{i,2}, ..., S_{i,N} (represented by Sᵢ hereinunder, i represents block No., and 1 to N represent bit Nos. in each block) corresponding to the photo-sensor units 208. The device also has accumulating capacitors C_{i,1}, C_{i,2}, ..., C_{i,N} (represented by Cᵢ hereinunder) corresponding to the charge accumulating units 212, transfer switches ST_{i,1}, ST_{i,2}, ..., ST_{i,N} (represented by STᵢ hereinunder) corresponding to the transfer switches 213a and adapted for transferring the charges of the accumulating capacitors Cᵢ to load capacitors CX₁, CX₂, ....., CX_{N} (correspond to accumulating capacitors 223), and discharge switches SR_{i,1}, SR_{i,2}, ..., SR_{i,N} (represneted by SRᵢ hereinunder) corresponding to the discharge switches 213b and adapted for resetting the charge accumulating capacitors Cᵢ.

The photo-sensor Sᵢ, accumulating capacitors Cᵢ, transfer switches STᵢ and the discharge switches SRᵢ are arrayed in respective rows. The image reading device is sectioned into M blocks each including N pieces of photo-sensor units SY1, N pieces of accumulating capacitors CYᵢ, N pieces of transfer switches STᵢ and N pieces of discharge SRᵢ. For instance, when a line sensor is composed of 1728 of such units, these units are divided into M blocks, e.g., 54 blocks, each containing N units, e.g., 32 units. The gate electrodes of the transfer switches STᵢ and discharge switches SRᵢ arranged in arrays are connected to the matrix wiring portion 210. The gate electrodes of the transfer switches STY1 in each block are commonly connected in each block i. The gate electrodes of the discharge switches SRᵢ of each block are commonly connected the gate electrodes of the transfer switches in the next block.

The common wiring (gate driving lines G1, G2, ....., GN) of the matrix wiring 210 are driven by a gate driving unit 246. On the other hand, the signal outputs are connected on the block basis to the signal processing unit 247 through lead lines 214, i.e., signal output lines D1, D2, ....., DN which are arranged in the form of a matrix.

The gate electrodes (light-shielding layers 202) of the photo-sensor units S₁,₁, ..., S_{1,N}, S_{2,1}, ..., S_{M,N} are connected to a driving source 250 and are supplied with negative bias voltage.

The gate driving lines G1, G2, ....., GN are successively supplied with selection pulses VG1, VG2, VG3, ....., VGN from the gate driving unit 246. When the gate driving line G1 is selected, the transfer switch ST₁ is turned on and the charges accumulated in the charge accumulating capacitor C1 are transferred to the load capacitors CX₁ to CX_{N}. Then, the next gate driving line G2 is selected so that the next transfer switch ST₂ is turned on, whereby the charges accumulated in the charge accumulating capacitor C₂ are transferred to the load capacitors CX₁ to CX₃₂ and, at the same time, the accumulating capacitor C1 is reset by means of the discharge switch SR₁. In the like manner, driving lines G3, G4, ....., GN are successively selected and reading operation is successively conducted. This operation is conducted for each of the plurality of blocks. The outputs VX1, VX2, ....., VXN are transmitted to the input sections D1, D2, ....., DN of the signal processing unit 247 so as to be changed into a serial output signal from the signal processing unit 247.

It will be understood that according to this structure also the undesirable effect of dark current is eliminated so as to exhibit improved S/N ratio and high linearity of the light-quantity-dependency, by changing the photoelectric converting semiconductor layer into a depletion layer, through application of a suitable level of negative bias voltage to the gate electrodes of the photo-sensor Sᵢ.

Fig. 9 is a timing chart illustrating a method of operating photo-sensor units in the image reading apparatus embodying the present invention. In this case, the semiconductor layers 12 shown in Figs. 2A and 3A are of n-type.

Referring to Fig. 9, a voltage V₀ is applied between the main electrode 117 or 217 and the main electrode 116 or 216, maintaining the main electrode 116 or 216 at a base level. The voltage V₀ is a positive voltage, i.e., the condition of V₀ > 0 is met.

Throughout the reading period T₁ of the sensor operation, a bias voltage V₁ is applied by a driving unit 250 (see Fig. 4 or 6) to the light-shielding layer 112 or 202 constituting an electrode. In view of the fact that the semiconductor layer 14 is of n-type, the bias voltage is selected to meet the condition of V₁ < 0.

Another voltage V₂ is applied to the light-shielding layer 112 or 202 in the non-reading period T₂ of the sensor operation. The voltage V₂ is selected to meet the condition of V₁ < V₂ < 0.

By shifting the level of the bias voltage to the positive side during the non-reading period T₂₃, it is possible to remarkably increase the rate of rise of the output current as will be understood from the following description.

Figs. 10A and 10B are waveform charts for explaining the change in the output current. More specifically, Fig. 10A shows the change in the output current as observed when the light pulse is applied immediately before the commencement of the reading operation, while Fig. 10B shows the change in the output current as observed when the light has been applied down to a moment immediately before the commencement of the reading operation.

Referring to Fig. 10A, it is assumed here that the bias voltage V₁ and the pulse voltage V₂ are -3V and -2.8V, respectively. When the pulse voltage V₂ is applied to the light shielding layer 112 or 202 to start the reading, the potential of the light-shielding layer 112 or 202 is shifted to the positive side so that a large electric current flows due to injection of electrons into the semiconductor layer 14 from the main electrode 116 or 216. The thus injected electrons serve to promote the re-bonding of electrons to holes in the semiconductor layer 14. In consequence, the semiconductor layer 14 has a smaller number of holes so that, when the light is applied, the rise of the output current is slightly delayed as compared with the case where the potential of the light-shielding layer 112, 202 is fixed. For information, the change in the output current as observed when the potential of the light shielding layer is fixed is shown by a broken-line curve. Nevertheless, the waveform of the output current conforms with the light pulse so that the amount of charges accumulated by the output current represents the light information carried by the incident light.

Referring now to Fig. 10B, it will be seen that the output current corresponds to the light pulse also in the case where the light has been applied to a moment immediately before the commencement of reading. Namely, the re-bonding of holes in the semiconductor layer 14 is promoted also in this case by the electrons injected into the semiconductor layer 14 as a result of application of the pulse voltage V₂ to the light shielding layer 112 or 212. Therefore, when the bias voltage V₁ is resumed on the light shielding layer 112 or 212, there is no surplus hole, so that the current level corresponding to the dark state is maintained to enable the output current to rise in response to the light input.

It is thus possible to eliminate inconveniences such as those caused when the potential of the light shielding layer 112 or 212 is fixed at the bias level V₁ (see broken-line curve in Fig. 9) and the unfavourable effect produced by the preceding output signal on the succeeding electrode, by applying the pulse voltage V₂ to the light shielding layer 112 or 212 immediately before the commencement of the reading so as to reset the photo-sensor.

It is therefore possible to obtain an output signal which precisely correspond to the incident light and, at the same time, to attain a higher response speed to the input light and higher speed of the reading operation.

Thus, the output signals from the photo-sensors are accumulated in the capacitors so as to obtain light information. This method of operating photo-sensor units, however, is only illustrative and other types of driving method are usable provided that they produce an output current precisely corresponding to the incident light.

The carriers carrying the electric current flowing through the semiconductor layer of the photo-sensor units are electrons. It will be obvious to those skilled in the art that described embodiments can be realized equally by using p- or i-type semiconductor layer 14 which employ holes as the carriers of the electric current, though the polarities of the voltages have to be inverted. Thus, the voltages are selected to meet the condition of V₁ < V₂ < 0 when the carriers are electrons as in the described embodiments, whereas, when the carriers are holes, the voltages are selected to meet the condition of V₁ > V₂ > 0.

When the semiconductor layer 14 is of i-type, the carriers carrying the electric current are determined in accordance with the conduction type of the ohmic contact layer 15 or 205.

In the described method of operating photo-sensor units, it is possible to completely eliminate any influence of the preceding reading output by applying to the light shielding layer 112 a voltage of the same polarity as the bias voltage but having a smaller absolute value than the bias voltage, during the non-reading period of the operation. In consequence, the response to the input light is improved and the reading output correctly corresponding to the operation. In consequence, the response to the input light is improved and the reading output correctly corresponding to the input light can be obtained stably. Thus, when using this method of operating photo-sensor units in an image reading device, the response to incident light exhibited is much superior as compared with that when using conventional methods of operating photo-sensor units.

A device to which the method can be applied can be constructed such as to have a line sensor having a multiplicity of pixel sensors each having the described construction and operation. With such a line sensor, it is possible to read the original image at a high speed.

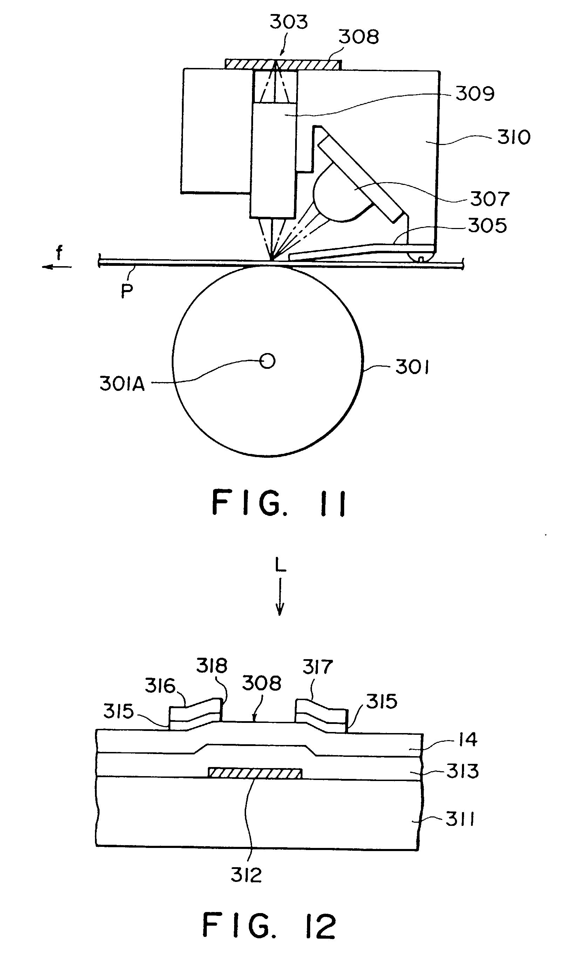

Fig. 11 shows still further image reading device for applying the method of operating photo-sensor units according to the present invention. This device features the use of a real-size line sensor. An original P is adapted to be fed by a feed roller 301 in a direction which is indicated by an arrow f. The feed roller 301 has a shaft which is rotatably supported on a suitable portion of the body portion of an image reading apparatus. The image reading apparatus further has a reading section 303 disposed such as to oppose to the feed roller 301. The reading section 303 includes a leaf spring 305 which is a member for elastically pressing the original P onto the feed roller 301 over the entire width of the original P, an LED j array 307 as means for illuminating the original P, an optical system 309 composed of converging optical fibers for converging the light reflected from the original P, a photoelectric conversion section 308 including photoelectric conversion elements (photo-sensors) for converting the converged light into electric signals, and a structural part 310which holds the above-mentioned constituents of the reading section 303.

In operation, the feed roller 301 is driven by a suitable driving means (not shown) so that the original P pressed onto the feed roller 301 by the pressing member 305 is fed in the direction of the arrow f. During feeding of the original P, the image carrying surface of the original is illuminated by the LED array 307 and the light reflected from the image-carrying surface is transmitted through the optical system 309 to the photoelectric conversion section 308, whereby the image on the original P is read successively.

Fig. 12 shows an example of the photo-sensor unit constituting the photoelectric conversion section 308 as used in the present invention. The photo-sensor has an insulating substrate 311 made of glass or ceramics, on which are formed an auxiliary electrode 312 and an insulating layer 13. The auxiliary electrode 312 and the insulating layer 13 are overlain by a semiconductor layer 14 which in turn is overlain by a pair of main electrodes 316 and 317 through an intermediary of a doped semiconductor layer 315 for attaining ohmic contact. The space between the main electrodes 316 and 317 constitutes a light-receiving window 318. The configurations and other conditions of the electrodes 312, 316 and 317 may be the same as those in the embodiment described in connection with Figs. 3A to 3B.

In operation, the light L reflected by the image impinges upon the surface of the semiconductor layer 14 through the light-receiving window 318, while a driving voltage of a high level is applied between the main electrode 317 and the main electrode 316 such that the electrode 317 has the higher potential. In consequence, a change is caused in the electric current flowing through the semiconductor layer 14 between the electrodes 316 and 317, and this change in the electric current is picked up as the output signal representing the read image data. It is possible to stabilize the output of the photo-sensor and to attain a high degree of correspondence between the intensity of the received light and the level of the output current, by applying to the auxiliary electrode 312 a suitable level of voltage as discussed in this specification.

The sensor unit corresponds to one bit (cell) of the image reading. It is possible to form a real-size one-dimensional line sensor by arraying a plurality of such sensor units on a substrate 11. For instance, by arraying 1728 pieces of such sensor unit in the direction of width of the original P, i.e., in the direction perpendicular to the original feeding direction indicated by an arrow in Fig. 11, it is possible to obtain a reading resolution of 8 lines/mm over a width (216 mm) of A-4 size paper. As in the embodiment explained in connection with Figs. 3A to 3C, the image reading device of this embodiment further has charge accumulating units (capacitor units) for accumulating the outputs from the photo-sensor units, switch units for transferring the accumulated charges for the purpose of signal processing, and necessary wiring patterns. These units may be formed on the substrate in a single production process.

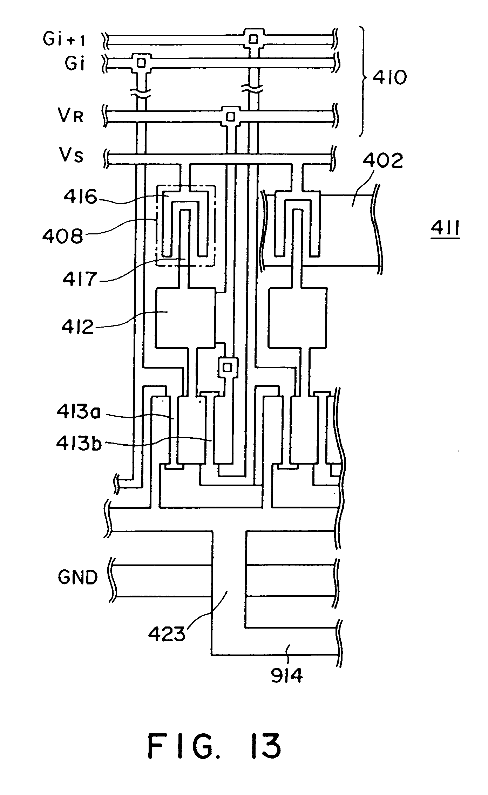

Fig. 13 is a plan view of a further portion for applying the method of operating photo-sensor units in which the photo-sensor units, charge accumulating units and switch units are formed integrally.

This image reading device has a plurality of units each having a gate matrix wiring portion 410, a photo-sensor unit 408, a charge accumulating unit 412, a switch unit 413 including a transfer switch 413a and a discharge switch 413b for resetting the charge accumulating unit 412, a wiring for transferring the output from the transfer switch 413a to a later-mentioned signal processing unit, and a load capacitor 423 for accumulating and reading the charges transferred through the transfer switch 413a. These constituents may be arranged in a laminated structure similar to that constituted by elements 210, 208, 212, 213 and 223 in the embodiment shown in Fig. 3A to 3C.

In Fig. 13, numerals 416 and 417 denote electrode wirings serving as source and drain electrodes, respectively, while 402 denotes an auxiliary electrode wiring serving as a gate electrode. The auxiliary electrode is connected to a later-mentioned driving unit. This embodiment of image reading device is devoid of any light-incidence window because it is not designed to be illuminated from the reverse side of the substrate 411.

The line sensor having the described construction can be produced by a single process because all of the constituents such as the photo-sensor unit,charge accumulating unit, transfer switch, discharge switch and matrix wirings have laminated structures including layers such as the photoconductive semiconductor layer and the insulating layer.

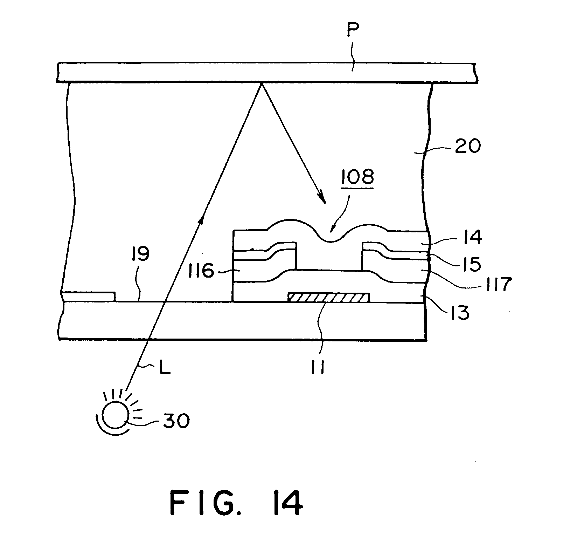

The described devices are of staggered type in which the main electrodes and the light-shielding portions are arranged on opposite sides of the semiconductor layer. This, however, is not exclusive and the same advantages are brought about by a modification in which, as shown in Fig. 14, main electrodes 116, 117 made of Aℓ or the like material are formed on the same side of the semiconductor layer 14 as the light-shielding layer 112.

As will be understood from the foregoing description, the present invention provides a method of operating photo-sensor units having a sensor portion which is improved to meet various demands so as to ensure a stable reading of image with a high quality of the reading output.

In addition, the method of operating photo-sensor units according to the invention enables the outputs of the photo-sensor units to be adjusted easily, so as to provide an improved output distribution along the length of a one-dimensional line sensor when such a line sensor is used.

In consequence, any expensive correction circuit which hitherto has been necessitated is completely eliminated or, if not, the correction circuit may be substituted by a less-expensive one.

This in turn lowers the cost of production of image reading devices incorporating such method of operating photo-sensor units.

## Claims

1. A method of operating photo-sensor units, each photo-sensor unit (108; 208) including
a light-shielding layer (112; 202) made of an electrically conductive material and formed on a light-transmitting substrate (11; 201),
an insulating layer (13; 203) formed on said light-shielding layer (112; 202),
a semiconductor layer (14) formed on said insulating layer (13, 203), and
a pair of upper electrodes (116, 117; 216, 217) provided on said semiconductor layer (14) and spaced from each other, the space between said upper electrodes (116, 117; 216, 217) constituting a light-receiving portion, wherein light (L) is applied from the reverse side of said light-transmitting substrate (11; 201) through a window (19; 219) in said light-shielding layer (112; 202), said insulating layer (13; 203), said semiconductor layer (14) and said upper electrodes (116, 117; 216, 217) onto an image-carrying original (P) which is then reflected by said original (P) so that light reaches said light receiving portion of said photo-sensor unit (108; 208), said method of operating said photo-sensor units (108; 208) being **characterized by** the steps of
applying a first bias voltage (V₁) having the polarity of the carrier mainly carrying a photoelectric current generated in said semiconductor layer (14) to each of said light-shielding layers (112; 202) in a reading period (T₁), and
applying a second bias voltage (V₂) having the same polarity as said first bias voltage (V₁) and an absolute value smaller than that of said first bias voltage (V₁) to each of said light-shielding layer (112; 202) in a non-reading period (T₂).

2. A method according to claim 1, **characterized in that** said second bias voltage (V₂) is applied to each of said light-shielding layers (112; 202) for a predetermined period immediately before the commencement of a reading operation.

3. A method according to claim 1 or 2, **characterized in that** the level of said bias voltage controlled by a voltage control means (250; 250A) is high enough to change said semiconductor layer (14) into a depletion layer over the entire thickness of said semiconductor layer (14).

4. A method according to claim 1 or 2, **characterized in that** a plurality of said photo-sensor units (108; 208) are arrayed on said substrate (11; 201; 311) so as to constitute a one-dimensional sensor array.

5. A method according to claim 1 or 2, **characterized by** the steps of irradiating said original (P) by a light source (307).

6. A method according to claim 1 or 2, **characterized by** the steps of conveying said original (P) by a conveying means (301).

## Patentansprüche

1. Verfahren zum Betreiben von Photosensoreinheiten, wobei jede Photosensoreinheit (108; 208)
eine aus einem elektrisch leitfähigen Material hergestellte und auf einem Licht-durchlässigen Substrat (11; 201) ausgebildete Licht-abschirmende Schicht (112; 202),
eine auf der Licht-abschirmenden Schicht (112; 202) ausgebildete Isolationsschicht (13; 203),
eine auf der Isolationsschicht (13; 203) ausgebildete Halbleiterschicht (14), und
ein Paar auf der Halbleiterschicht (14) ausgebildete und voneinander beabstandete obere Elektroden (116, 117; 216, 217) enthält, wobei der Raum zwischen den oberen Elektroden (116, 117; 216; 217) einen Licht-empfangenden Abschnitt bildet und Licht (L) von der umgekehrten Seite des Licht-durchlässigen Substrats (11; 201) über ein Fenster (19; 219) in der Licht-abschirmenden Schicht (112; 202), der Isolationsschicht (13; 203), der Halbleiterschicht (14) und den oberen Elektroden (116, 117; 216, 217) auf ein Bild-tragendes Original (P) fällt, das dann von dem Original (P) reflektiert wird, so daß das Licht den Licht-empfangenden Abschnitt der Photosensoreinheit (108; 208) erreicht,
**gekennzeichnet durch** die Schritte
Anlegen einer ersten Vorspannung (V₁) mit der Polarität des Trägers, der hauptsächlich einen in der Halbleiterschicht (14) erzeugten photoelektrischen Strom trägt, an jede Licht-abschirmende Schicht (112; 202) in einem Lese-Zeitabschnitt (T₁) und
Anlegen einer zweiten Vorspannung (V₂) mit der gleichen Polarität wie die erste Vorspannung (V₁) und einem absoluten Wert der kleiner als der der ersten Vorspannung (V₁) ist, an jede Licht-abschirmende Schicht (112; 202) in einem Nicht-Lese-Zeitabschnitt (T₂).

2. Verfahren nach Anspruch 1, **dadurch gekennzeichnet, daß** die zweite Vorspannung (V₂) an jede Licht-abschirmende Schicht (112; 202) für einen vorbestimmten Zeitabschnitt unmittelbar vor dem Beginn eines Lesevorgangs angelegt wird.

3. Verfahren nach Anspruch 1 oder 2, **dadurch gekennzeichnet, daß**
der Pegel der durch eine Spannungssteuereinrichtung (250; 250A) gesteuerten Vorspannung zur Änderung der Halbleiterschicht (14) in eine Sperrschicht über die gesamte Dicke der Halbleiterschicht (14) hoch genug ist.

4. Verfahren nach Anspruch 1 oder 2, **dadurch gekennzeichnet, daß**
eine Vielzahl der Photosensoreinheiten (108; 208) auf dem Substrat (11; 201; 311) in einem Feld angeordnet ist, um ein eindimensionales Sensorfeld auszubilden.

5. Verfahren nach Anspruch 1 oder 2, **gekennzeichnet durch** den Schritt
Bestrahlen des Originals (P) durch eine Lichtquelle (307).

6. Verfahren nach Anspruch 1 oder 2, **gekennzeichnet durch** den Schritt
Befördern des Originals (P) durch eine Beförderungseinrichtung (301).

## Revendications

1. Procédé pour faire fonctionner des éléments photodétecteurs, chaque élément (108; 208) photodétecteur comportant :
une couche (112; 202) opaque à la lumière faite d'un matériau électriquement conducteur et formée sur un substrat (11; 201) transmettant la lumière,
une couche (13 ; 203) isolante formée sur ladite couche (112 ; 202) opaque à la lumière,
une couche (14) semiconductrice formée sur ladite couche (13, 203) isolante, et
une paire d'électrodes (116, 117; 216, 217) supérieures disposées sur ladite couche (14) semiconductrice, et espacées l'une de l'autre, l'espace entre lesdites électrodes (116, 117; 216, 217) supérieures constituant une partie photoréceptrice, dans laquelle de la lumière (L) est appliquée par la face arrière dudit substrat (11; 201) transmettant la lumière à travers une fenêtre (19; 219) pratiquée dans ladite couche (112; 202) opaque à la lumière, ladite couche (13; 203) isolante, ladite couche (14) semiconductrice et lesdites électrodes (116, 117; 216, 217) supérieures, sur un original (P) portant une image, et est ensuite réfléchie par ledit original (P) de façon que la lumière atteigne ladite partie photoréceptrice dudit élément (108; 208) photodétecteur, ledit procédé pour faire fonctionner lesdits éléments (108; 208) photodétecteur étant caractérisé par les étapes qui consistent :
à appliquer une première tension (V₁) de polarisation ayant la polarité du porteur acheminant principalement un courant photoélectrique généré dans ladite couche (14) semiconductrice à chacune desdites couches (112; 202) opaques à la lumière lors d'une période (T₁) de lecture, et
à appliquer une seconde tension (V₂) de polarisation ayant la même polarité que ladite première tension (V₁) de polarisation et une valeur absolue inférieure à celle de ladite première tension (V₁) de polarisation, à chacune desdites couches (112; 202) opaques à la lumière au cours d'une période (T₂) de non-lecture.

2. Procédé selon la revendication 1, caractérisé en ce que ladite seconde tension (V₂) de polarisation est appliquée à chacune desdites couches (112; 202) opaque à la lumière pendant une période prédéterminée immédiatement avant le commencement d'une opération de lecture.

3. Procédé selon la revendication 1 ou 2, caractérisé en ce que le niveau de ladite tension de polarisation commandé par des moyens (250; 250A) de commande de tension, est suffisamment élevé pour transformer ladite couche (14) semiconductrice en une couche de déplétion sur toute l'épaisseur de ladite couche (14) semiconductrice.

4. Procédé selon la revendication 1 ou 2, caractérisé en ce qu'un ensemble desdits éléments (108; 208) photodétecteurs sont regroupés sur ledit substrat (11; 201; 311) de façon à constituer un groupement monodimensionnel de capteurs.

5. Procédé selon la revendication 1 ou 2, caractérisé par l'étape qui consiste à exposer ledit original (P) à une source (307) lumineuse.

6. Procédé selon la revendication 1 ou 2, caractérisé par l'étape qui consiste à transporter ledit original (P) à l'aide de moyens (301) transporteurs.
